# EUROPEAN PATENT APPLICATION

(11) **EP 3 731 605 A1**
(43) Date of publication of application: **28.10.2020**
(21) Application number: 19170594.6
(22) Date of filing: 23.04.2019
(51) Int. Cl.: H05K 1/02, H02M 1/44

(54) **ELECTRIC CIRCUIT ARRANGEMENT FOR A POWER CONVERTER**

(71) Applicant: Mahle International GmbH, 70376 Stuttgart (DE)
(72) Inventor: CLOSA KOBAYASHI, Alejandro Hiroshi, 46019 Valencia (ES); ESMORIS BERTOA, Antón, 46010 Valencia (ES); GONZALEZ ESPIN, Francisco, 03205 Elche (ES); JORDAN HERRERO, Donato, 46178 La Yesa (ES); PARDO PERIS, Juan Francisco, 46800 Xàtiva (ES)
(74) Representative: BRP Renaud & Partner mbB Rechtsanwälte Patentanwälte Steuerberater

(57) **Abstract**

The invention relates to an electric circuit arrangement (1) for a power electronics module (30). The circuit arrangement (1) comprises a substrate (5) with a first layer (2a) from an electrically insulating material, which forms a topside (3) of the substrate (5), and with a second layer comprising a layer from an electrically insulating material, which forms an underside (4) of the substrate (5). Between the first and second layers (2a, 2b) a shielding layer (2c) from an electrically conductive material is provided. On the topside (3) of the substrate (5) at least one transistor (6) is arranged, which comprises a source terminal (14a), a drain terminal (14b) and a gate terminal (14c). On the underside (4) of the substrate (5) a cooling body (7) is arranged, which is thermally connected via the substrate (5) to the at least one transistor (6). The at least one transistor (6) is electrically connected via a bond connection (12) to the shielding layer (2c).

## Description

The invention relates to an electric circuit arrangement for a power electronics module as well as a power electronics module with such an electric circuit arrangement. The invention further relates to an electronic converter comprising at least two of such power modules.

Electronic circuits with electric semiconductor switches in the form of power semiconductors, also called "electric circuit arrangement" hereunder, undergo, as part of a power converter, high-frequency switching-overs between a conducting and a blocking state. These switching-overs, due to the capacities present in the circuits, often cause an undesirable EMI (electromagnetic interference).

The requirement of the present invention is to propose an easy-to-produce electronic circuit arrangement, in particular for a power converter, in which the generation of electromagnetic interferences can be distinctly reduced as compared to conventional electric circuit arrangements.

This requirement is met by the subject of the independent patent claims. Preferred embodiments are the subject of the dependent patent claims.

The basic idea of the invention thus consists in providing an electric circuit arrangement with at least one transistor for power conversion with a shielding layer from electrically conductive material and to electrically connect this shielding layer with the aid of a bond connection, i.e. by means of wire bonding, or - alternatively or additionally - by means of a via connection with a power semiconductor. The electrical connection created in this way between the power semiconductor and the shielding layer leads to a considerable reduction of the electromagnetic interferences generated by an electric power converter during operation of the circuit arrangement / the power semiconductor being part of the power converter. Using a bond or via connection makes it possible to implement the necessary electrically conductive connection between the power semiconductor and the shielding layer in a technically simple manner, which leads to cost advantages during the production of the electric circuit arrangement and thus the power converter.

The inventive electric circuit arrangement, in particular for a power electronics module, involves a substrate. The substrate, in turn, comprises a first layer from an electrically insulating and thermally conductive material, which forms a topside of the substrate, and a second layer from an electrically insulating material, which forms an underside of the substrate. The terms "topside" and "underside" refer, without limiting generality, to a possible position of the circuit arrangement when installed in a power converter. But it is of course possible to install and use the circuit arrangement in positions, in which the topside is arranged in gravitational direction below the underside. A lateral installation state is also feasible.

The materials used for both layers may be identical or may be materials with electrically insulating and thermally conductive properties.

According to the invention a shielding layer of an electrically conductive material is arranged between the first and second layer. At least one power semiconductor comprising at least one terminal, preferably a source terminal, a drain terminal and a gate terminal, is arranged on the topside, which means that this power semiconductor can be implemented as a transistor, preferably a field effect transistor. Such a transistor can, if required, have further or less electric terminals. According to the invention the at least one power semiconductor is electrically connected by means of a bond connection and/or a via connection to the shielding layer.

According to another preferred embodiment the shielding layer is electrically connected to a connection point on the topside of the substrate by means of a bond connection or a via connection and electrically insulated from the at least one power semiconductor.

According to a preferred embodiment a conductor track structure with conductor tracks from an electrically conductive material is integrated into the first layer. The conductor tracks comprise electric contacting portions which are exposed on the topside of the substrate. With this embodiment the shielding layer also comprises at least one contacting portion, which is exposed on the topside of the substrate. To realise the bond connection, the at least one contacting portion of the shielding layer is electrically connected by means of a bond wire and/or a via connection to one of the contacting portions of the conductor track structure.

In a particularly advantageous embodiment the contacting portion of the conductor track structure is electrically connected to the at least one terminal, preferably to the source terminal, of the power semiconductor.

According to a further preferred embodiment, the contacting portion of the shielding layer and the contacting portion of the conductor track structure are arranged spaced apart on the topside of the first layer. This measure simplifies attaching the bond connection.

Conveniently the distance between the contacting portion of the shielding layer and the contacting portion of the conductor track structure is max. 3mm. In this way the installation space needed for the bond connection can be kept small.

Especially preferably the bond wire connecting the two contacting portion has a wire length of max. 8 mm. In this way, the impedance of the bond connection can be kept small.

With an advantageous further development at least two, preferably more than two, transistors are arranged on the topside of the first layer. For each transistor the conductor track structure and the shielding layer comprise an electrically extended contacting portion, which is electrically connected to each other by means of a bond connection, preferably by means of bond wire. In this way a random number of transistors can in principle be connected to the shielding layer in the power converter, in order to reduce electrical interferences.

According to an advantageous further development, the power semiconductor comprises a transistor having a housing, from which at least the source terminal, the drain terminal and the gate terminal protrude towards the outside, in the manner of a connector pin. The three terminals, i.e. the source terminal, the drain terminal and the gate terminal, are each electrically connected to the electric contacting portions of the conductor track structure.

Conveniently the electrically conductive material of the shielding layer is copper or another suitable metal. Alternatively or additionally, the electrically insulating material of the first layer and alternatively or additionally of the second layer may be a ceramic material. The ceramic material can particularly be an aluminum oxide ceramics or an aluminum nitride ceramics. Alternatively, epoxy or a polyimide can be used.

Such a ceramic material has a number of advantages over conventional materials as for example flexible silicone. In particular, it is difficult to use flexible silicone in a process where building of electrical connections using bonding or vias is an automated process in which a high positional accuracy of the components is important. Moreover, flexible silicone may also be thermally damaged during the bonding process.

Especially preferably a layer thickness of the shielding layer is at least 35 µm. In this way it is ensured that the desired shielding effect is achieved.

According to another preferred embodiment, at least two shielding layers are arranged between the first and the second layer laterally spaced apart from each other. According to this embodiment, the at least two shielding layers are electrically isolated from each other. Alternatively, the at least two shielding layers can also be electrically connected to each other.

The present invention also relates to a power electronics module. The power electronics module comprises a housing, preferably made of plastic, in which a circuit arrangement according to the invention as described above is arranged. Furthermore, the circuit arrangement and an interface board comprising passive and/or active electronic elements as well as connectors are stacked upon each other inside the housing.

The present invention also relates to an electronic converter comprising at least two power modules according to the invention. Moreover, the at least two housing are arranged laterally next to each other and mounted onto a common cooling body, preferably on a common cooling plate. In this way, dissipation of waste heat from the electric circuit arrangements is significantly facilitated.

The present invention further relates to an electronic three phase power converter. The converter comprises a first, second and third supply connector for connecting a first, second and third voltage source assigned to a first, second and third phase of the power converter. The converter further comprises at least one power module introduced above. According to the invention, the shielding layer of the electric circuit arrangement of the module is connected to the at least one power semiconductor via a common mode filter being part of the power converter.

Further important features and advantages of the invention are revealed in the sub-claims, the drawings and the associated description of the figures by way of the drawings.

It is understood that the features mentioned above and described hereunder can be used also in other combinations or on their own, without leaving the scope of the present invention.

Preferred exemplary embodiments of the invention are depicted in the drawings and will now be explained in detail hereunder, wherein identical reference symbols refer to identical or similar or functionally identical components.

In the figures it is depicted schematically
- fig. 1: an example of an electronic converter according to the invention,
- fig. 2: a power module of the converter of fig. 1 in a perspective view,
- fig. 3: a circuit assembly according to the invention in an explosive view,
- fig. 4: illustrates the setup of the circuit arrangement of figure 3 according to a different example in a perspective view,
- fig. 5: the example of figure 4 in an explosive view,
- fig. 6: shows a circuit-diagram of the circuit arrangement of figures 1, 2,
- fig. 7, 8a,b: illustrates schematically a variant of the examples of figures 2 to 5, in which the bond connection is replaced by a via connection,
- fig. 9: in a circuit-type diagram another application example of the electric circuit arrangement.

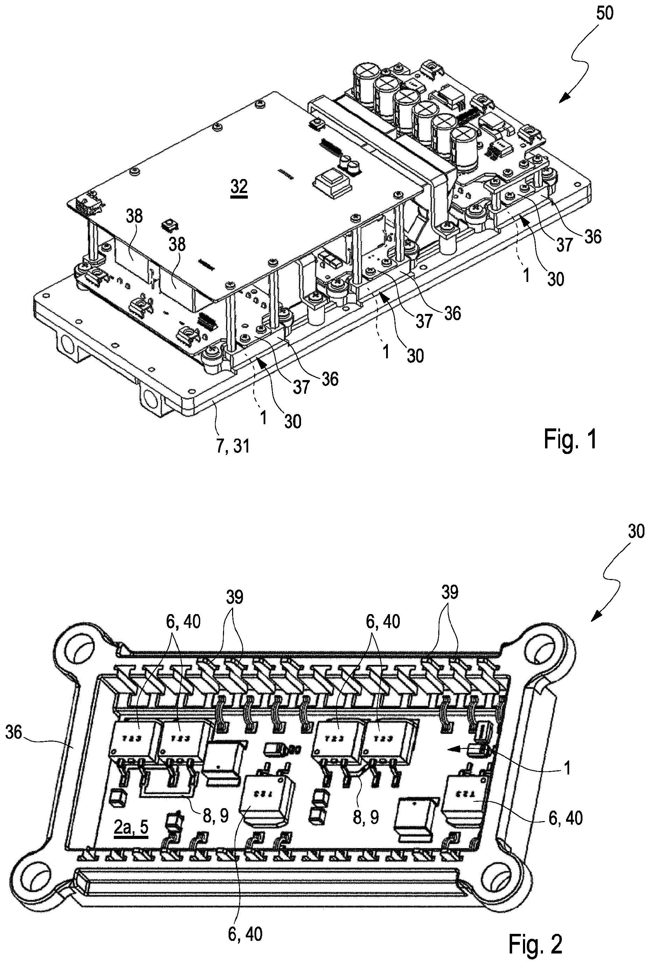

Figure 1 shows an example of an electronic converter 50. In the example, the converter 50 comprises three power modules 30. The three power modules 30 are arranged laterally next to each other and mounted onto a common cooling body 7 realized as a cooling plate 31. According to figure 1, each power module 30 comprises a housing 36 in which an electric circuit arrangement 1 according to the invention is arranged. Moreover, on each housing 36 an interface board 37 comprising active and/or passive electronic elements 38 as well as connectors are mounted.

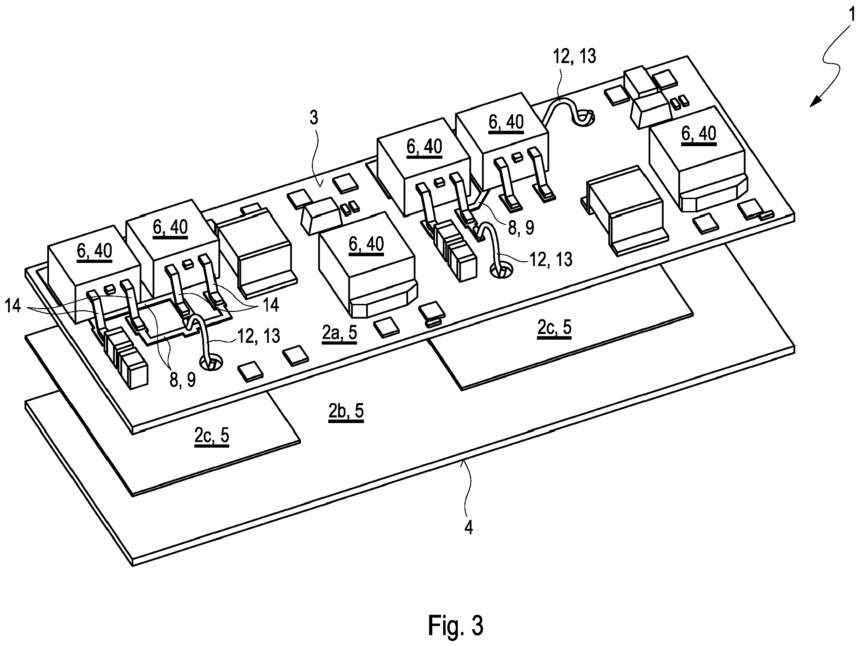

Figure 2 shows a single power module 30 in a more detailed view, figure 3 shows the circuit arrangement 1 of the module 30 of figure 2 in an explosive view. As can be seen from figure 2, each housing 36 can have one or more terminals 39 for connecting the power module 30 to the interface board 37.

According to figure 1, a common control board 32 comprising control electronics (not visible in the view of figure 2) for controlling the power modules 30 can be mounted on top of the modules 30.

According to figure 3, the circuit arrangement 1 comprises a substrate 5 with a first layer 2a from an electrically insulating and thermally conductive material, preferably of a ceramic material, which forms a topside 3 of the substrate 5. Furthermore, the circuit arrangement 1 comprises a second layer 2b from an electrically insulating material, which forms an underside 4 of the substrate 5. Between the first and the second layer 2b are arranged, preferably sandwich-like, two shielding layers 2c from an electrically conductive material. The two shielding layers 2c are arranged laterally spaced apart from each other. In the example of figure 3, the two shielding layers are electrically isolated from each other. In an alternative variant, the two shielding layers 2c can also be electrically connected to each other. Conveniently, a layer thickness of the shielding layers 2c is 35 µm or more.

As indicated in figures 2 and 3, a conductor track structure 8 with conductor tracks 9 from an electrically conductive material may be integrated into the first layer 2a. If the circuit arrangement 1 with the transistors 6 is to be integrated into a power converter, the transistors 6 may be electrically wired via the conductor tracks 8.

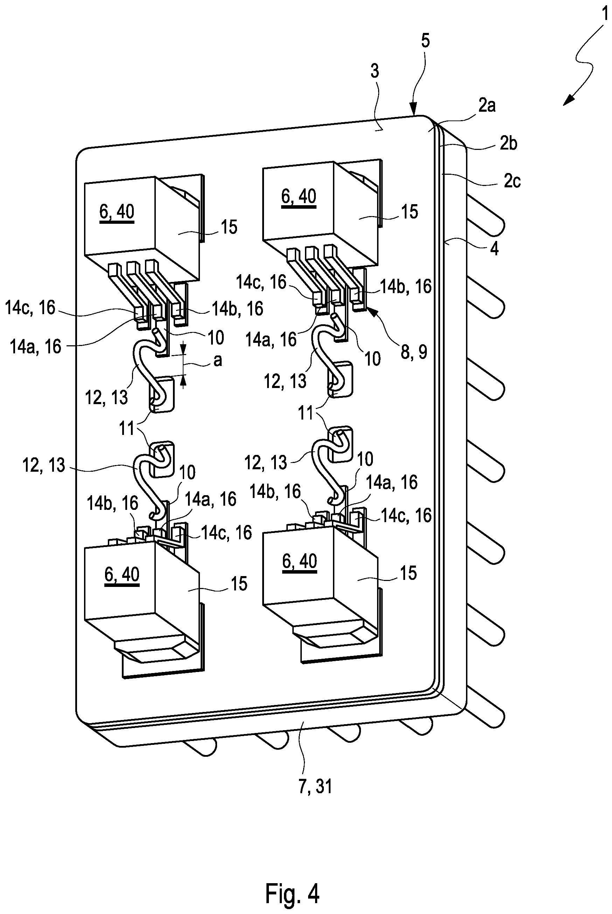

As shown in figure 4, the conductor tracks 9 comprise electric contacting portions 10, which are exposed on the topside 3 of the substrate 5. Each transistor 6 comprises a transistor housing 15, from which various terminals 14 protrude.

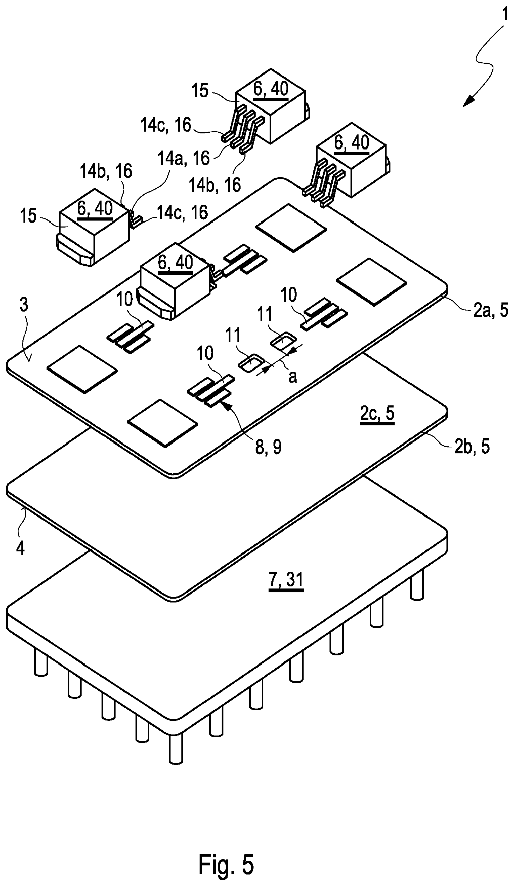

Figures 4 and 5 illustrate the setup of the circuit arrangement 1 of figure 3 according to a different example. Figure 4 shows a perspective view, figure 5 an explosive view of the same example. Each of the transistors 6, which may be configured as an FET, comprises, according to figures 4 and 5, a source terminal 14a, a drain terminal 14b and a gate terminal 14c. According to figures 4 and 5, the terminals 14 of each transistor 6, namely the source terminal 14a, the drain terminal 14b and the gate terminal 14c, protrude to the outside in the manner of connector pins, which are electrically connected to the electric contacting portions 10 of the conductor track structure 8. According to figures 4 and 5, four power semiconductors 40 in the form of transistors 6 are arranged on the topside 3 of the substrate 5. In variants of the example a different number of transistors 6 may be arranged.

The electrically conductive material of the shielding layer 2c may, like the conductor track structure 8, be copper or another suitable metal. The electrically conductive materials of the two layers 2a, 2b may be identical or different from one another. The electrically insulating material of the first and second layers 2a, 2b may in particular be a ceramic.

Furthermore the shielding layer 2c for each of the transistors 6 comprises a respective contacting portion 11, which is exposed on the topside 3 of the substrate 5 by providing a respective hole in the first layer 2a.

Each contacting portion 11 of the shielding layer 2c is connected via a respective bond connection 12 with an associated contacting portion 10 of the conductor track structure 8. In this way the source terminal 14a of each transistor 6 is electrically connected to the shielding layer 2c. Each bond connection 12 is formed by a bond wire 13, which at one end is materially bonded to the contacting portion 10 of the conductor track structure 8 and at the other is materially bonded to the contacting portion 11 of the shielding layer 2c. The bond wire 13 preferably comprises a wire length of max. 8 mm. The respective contacting portion 11 of the shielding layer 2c and the associated contacting portion 10 of the conductor track structure 8 are, as shown in figure 4, arranged at a distance a from each other on the topside 3 of the first layer 2a. The distance is conveniently at max 3mm.

As further revealed in figures 4 and 5, the cooling body 7 in the form of a cooling plate 31 is arranged on the underside 4 of the substrate 5, which is thermally connected via the substrate 5 to the transistors 6.

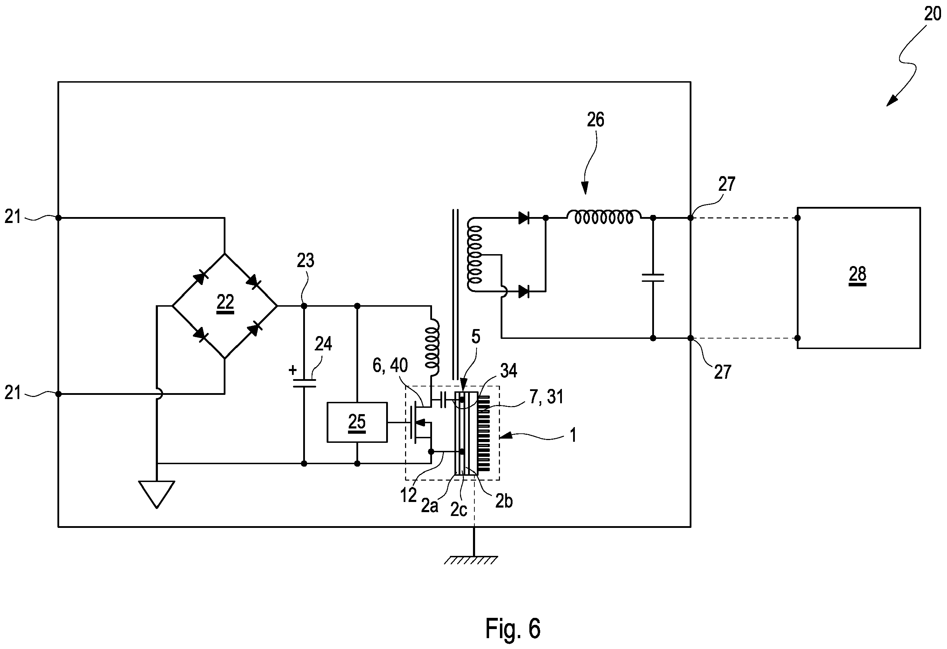

Figure 6 illustrates by way of a circuit-type diagram an application example of the electric circuit arrangement 1. Here the circuit arrangement 1 is used in a power converter, which is implemented as an isolated AC-DC converter. In the AC-DC converter 20 the transistors 6 of the electronic circuit arrangement 1 function as power semiconductors 40. The AC-DC converter 20 has a converter input 21 with a rectifier circuit 22, to which an AC voltage signal can be supplied. Via a circuit output 23 the rectifier circuit 22 transitions into the circuit arrangement 1 with a transistor 6, which is configured as a power semiconductor 40.

An AC voltage signal is converted into a DC voltage by means of the rectifier circuit 22 and smoothed after conversion with the aid of a capacitor 24 . The DC voltage is applied at the source terminal 14a of the transistor 6 (in figure 6 only a single transistor 6 is shown for clarity's sake). The transistor 6 is controlled by a pulse width modulation controller 25, which is electrically connected to the gate terminal 14c of the transistor 6. On the output side, i.e. via the drain terminal 14b, the transistor 6 is connected to a high frequency transformer. The DC signal filtered by means of an output filter 26 is provided at the output terminals 27 of the AC-DC converter 20. The output terminals 27 can be used to connect an external load 28.

It becomes obvious from figure 6, that the common noise current flows from the drain terminal 14b of transistor 6 through a parasitic capacitance 34 to the shielding 2c. The common noise current then flows back to the source terminal 14a of the transistor 6 through the bond connection 12. In this way it is ensured that the common noise current will flow through a controlled path.

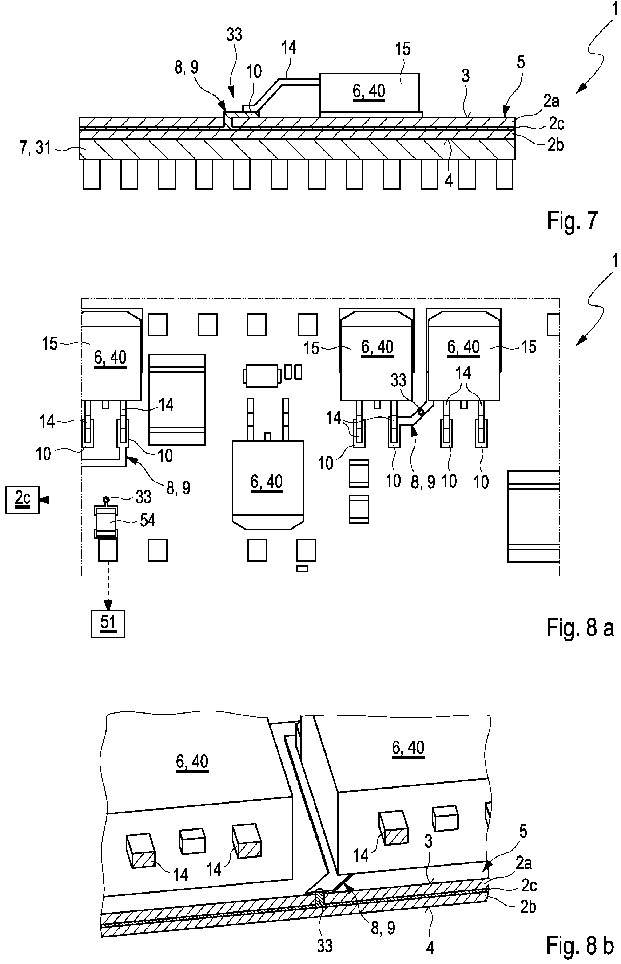

Figure 7 illustrates schematically a variant of the preceding examples. According to the example of figure 7, the bond connection 12 is replaced by means of a via connection 33. The technical realization of such a via connection 33 in the examples of figures 3 to 5 is shown in figures 8a, 8b. In the example of figures 8a, 8b, transistor 6 formed by power semiconductor 40 comprises terminal 14. Terminal 14 is connected to the shield layer 2c by means of via connection 33. Such a scenario is illustrated in figure 7 showing the circuit arrangement 1 of figure 2 in a partial view. In the arrangement of figure 6, a via connection 33 is clearly visible.

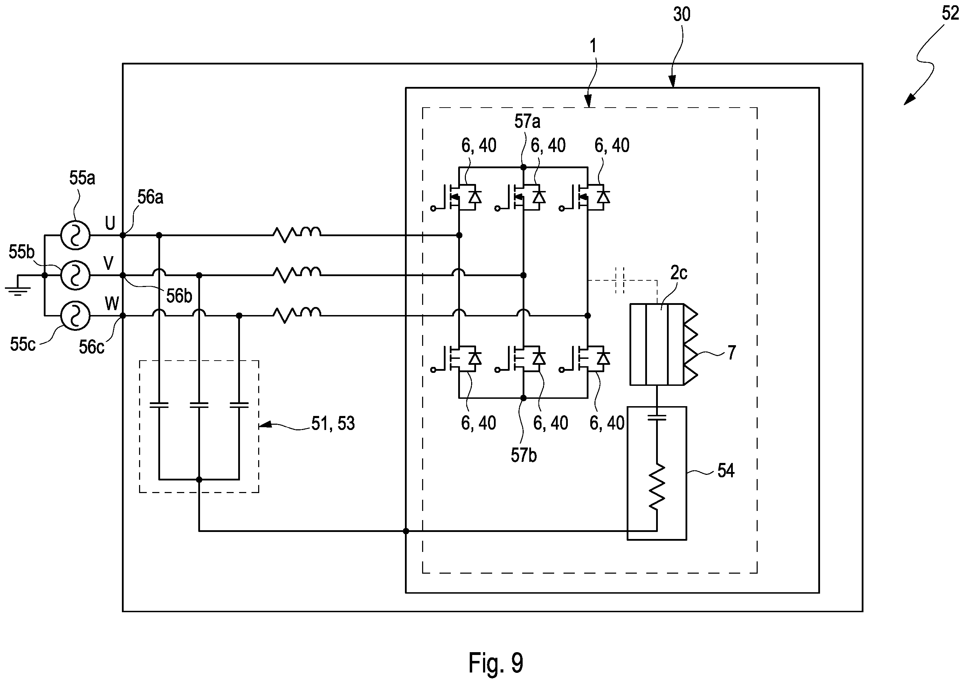

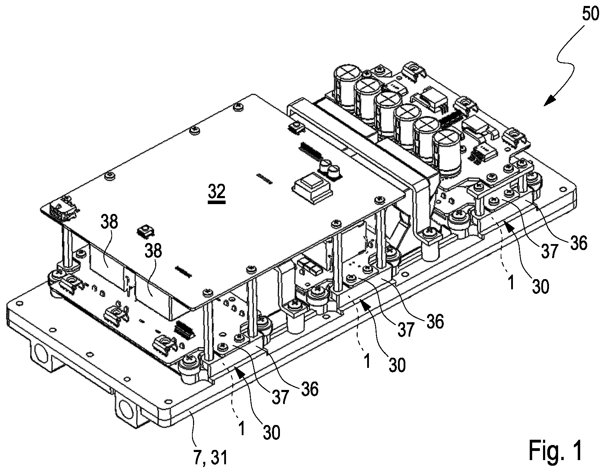

Figure 9 shows in a circuit-type diagram another application example of the electric circuit arrangement 1. Here, the power module 30 comprising the circuit arrangement 1 is used in a three phase power converter 52.

The converter 52 comprises a first, second and third supply connector 56a, 56b, 56c for connecting a first, second and third voltage source 55a, 55b, 55c forming a first, second and third phase U, V, W to the power converter 52. The converter 52 converts the AC signal of the three phases U, V, W into a common DC signal which is provided at DC output points 57a, 57b.

According to the example, the circuit arrangement 1 comprises six power semiconductors 40, wherein in each case two power semiconductors 40 electrically connected to one of the three voltage sources 55a, 55b, 55c forming the respective phase U, V, W.

In the example of figure 9, the shield layer 2c is not directly connected to the power semiconductors 40. Rather, the shield layer 2c is connected to the power semiconductors 40 indirectly via an external circuit node 53. This variant is particularly applicable to the three phase power converter 52 shown in figure 9. The external circuit node 51 can be implemented by means of common mode filter 51 of the three phase power converter 52. In the example of figure 9, the filter 51 comprises three capacitors arranged in parallel to each other.

As shown schematically in figure 8a, an additional filter 54 being part of the circuit arrangement 1 can be provided between the shield layer 2c and the external circuit node 53. The additional filter 54 and its electrical connection to the common mode filter 51 and to the shielding layer 2c is shown in figure 8a.

## Claims

1. An electric circuit arrangement (1) for a power electronics module (30),
- with a substrate (5) comprising a first layer (2a) from a thermally conductive and electrically insulating, material, which forms a topside (3) of the substrate (5), and comprising a second layer (2b) from a thermally conductive and electrically insulating material, which forms an underside (4) of the substrate (5),
- with at least one shielding layer (2c) from an electrically conductive material, arranged between the first and second layers (2a, 2b),
- with at least one power semiconductor (6) arranged on the topside (3) of the substrate (5), which comprises a plurality of terminals (14a, 14b, 14c), preferably at least a source terminal (14a), a drain terminal (14b) and a gate terminal (14c),
- wherein the underside (4) of the substrate (5) is arranged for contacting a cooling body (7)
- wherein the at least one power semiconductor (6) is electrically connected to the shielding layer (2c) by means of a bond connection (12) and/or a via connection (33).

2. The circuit arrangement according to claim 1,
**characterized in that**
- a conductor track structure (8) with conductor tracks (9) from an electrically conductive material is integrated into the first layer (2a), wherein the conductor tracks (9) comprise electric contacting portions (10), which are exposed on the topside (3) of the substrate (5),
- the shielding layer (2c) comprises at least one contacting portion (11), which is exposed on the topside (3) of the substrate (5),
- the at least one contacting portion (11) of the shielding layer (2c) is electrically connected by means of a bond wire (13) or a via connection to one of the contacting portions (10 of the conductor track structure (8) for forming a bond connection (12).

3. The circuit arrangement according to claim 2,
**characterized in that**
the contacting portion (10) of the conductor track structure (8) is electrically connected to the at least one terminal (14, 14a, 1b, 14c), preferably to the source terminal (14a), of the power semiconductor (6).

4. The circuit arrangement according to claim 2 or 3,
**characterized in that**
the contacting portion (11) of the shielding layer (2c) and the contacting portion (10) of the conductor track structure (8) are arranged spaced apart from each other on the topside (3) of the first layer (2a).

5. The circuit arrangement according to one of claims 2 to 4,
**characterized in that**
a distance (a) between the contacting portion (11) of the shielding layer (2c) and the contacting portion (10) of the conductor track structure (8) is of max 3mm.

6. The circuit arrangement according to one of claims 2 to 5,
**characterized in that**
the bond wire (13) connecting the two contacting portions (10, 11) comprises a wire length of max. 8 mm.

7. The circuit arrangement according to one of claims 2 to 6,
**characterized in that**
at least two, preferably a number of, power semiconductors (40) are arranged on the topside (3) of the first layer (2a), wherein for each power semiconductor (6) the conductor track structure (8) and the shielding layer (2c) each comprise an electric contacting portion (10, 11), which are electrically connected to each other by means of a bond connection (12), preferably by means of bond wire (13).

8. The circuit arrangement according to one of the preceding claims,
**characterized in that**
the at least one power semiconductor (6) comprises a transistor having a housing (15), from which at least one terminal (14), preferably the source terminal (14a) and/or the drain terminal (14b) and/or the gate terminal (14c), protrude to the outside in the manner of a connector pin (16) respectively, and which are each electrically connected to the electric contacting portions (10, 11) of the conductor track structure (8).

9. The circuit arrangement according to one of the preceding claims,
**characterized in that**
- the electrically conductive material of the shielding layer (2c) is copper or/and **in that**
- the electrically insulating material of the first and/or the second layer (2a, 2b) is a ceramic.

10. The circuit arrangement according to one of the preceding claims,
**characterized in that**
a layer thickness of the shielding layer (2c) is at least 35 µm.

11. The circuit arrangement according to one of the preceding claims,
**characterized in that**
at least two shielding layers (2c) are arranged between the first and the second layer (2a, 2b) laterally spaced apart from each other,
wherein the at least two shielding layers (2c) are electrically isolated to each other or electrically connected to each other.

12. A power electronics module (30), comprising:
- a housing (36), preferably made of plastic, in which a circuit arrangement (1) according to any of the preceding claims is arranged,
- wherein the circuit arrangement and an interface board (37) comprising actice and/or passive electronic elements (38) and/or connectors are stacked upon each other inside the housing (36).

13. An electronic converter (50) comprising at least two power modules (30) according to claim 12 wherein the at least two housings (36) are arranged laterally next to each other and mounted onto a common cooling body (7), preferably onto a cooling plate (31).

14. An electronic three phase power converter (52), comprising:
- a first, second and third supply connector (56a, 56b, 56c) for connecting a first, second and third voltage source (55a, 55b, 55c) forming a first, second and third phase (U, V, W),
- at least one power module (30) according to claim 12, wherein the shielding layer (2c) of the electric circuit arrangement (1) is connected to the at least one power semiconductor (40) via a common mode filter (51) of the power converter (52).

15. Three phase power converter (52) according to claim 14,
**characterized in that**
the common mode filter (51) is electrically connected to the three supply connectors (56a, 56b, 56c).
